Europäisches Patentamt

**European Patent Office**

Office européen des brevets

(19)

(11) **EP 1 421 393 B1**

(12) **EUROPÄISCHE PATENTSCHRIFT**

(45) Veröffentlichungstag und Bekanntmachung des Hinweises auf die Patenterteilung:
**19.01.2005 Patentblatt 2005/03**

(21) Anmeldenummer: **02806845.0**

(22) Anmeldetag: **29.08.2002**

(51) Int Cl.⁷: $G01R\ 15/24$, G01R 33/032

(86) Internationale Anmeldenummer:
**PCT/CH2002/000473**

(87) Internationale Veröffentlichungsnummer:
**WO 2003/071290 (28.08.2003 Gazette 2003/35)**

(54) **OPTISCHE STROMSENSOREN**

OPTICAL CURRENT SENSORS

CAPTEURS DE COURANT OPTIQUES

(84) Benannte Vertragsstaaten:
**AT BE BG CH CY CZ DE DK EE ES FI FR GB GR IE IT LI LU MC NL PT SE SK TR**

(30) Priorität: **31.08.2001 EP 01810843**

(43) Veröffentlichungstag der Anmeldung:
**26.05.2004 Patentblatt 2004/22**

(73) Patentinhaber: **ABB RESEARCH LTD.**
**8050 Zürich (CH)**

(72) Erfinder:
• **BOHNERT, Klaus**
**CH-5452 Oberrohrdorf (CH)**
• **NEHRING, Juergen**
**CH-5430 Wettingen (CH)**

(74) Vertreter: **ABB Patent Attorneys**
**c/o ABB Schweiz AG,**
**Intellectual Property (CH-LC/IP),**
**Brown Boveri Strasse 6**
**5400 Baden (CH)**

(56) Entgegenhaltungen:
**EP-A- 0 856 737          EP-A- 1 107 029**
**EP-A- 1 115 000          WO-A-96/26452**
**WO-A-99/17129**

• **K.BOHNERT ET AL.: "Temperature and Vibration Insensitive Fiber-Optic Current Sensor" JOURNAL OF LIGHTWAVE TECHNOLOGY, Bd. 20, Nr. 2, Februar 2002 (2002-02), Seiten 267-276, XP002220036 US**

EP 1 421 393 B1

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist. (Art. 99(1) Europäisches Patentübereinkommen).

## Beschreibung

Die vorliegende Erfindung betrifft das Gebiet der optischen Strom- oder Magnetfeldsensorik. Sie bezieht sich auf

- ein Verfahren zur Herstellung eines Sensors gemäss dem Oberbegriff des Patentanspruchs 1,
- auf einen optischen Strom- oder Magnetfeldsensor gemäss dem Oberbegriff des Patentanspruchs 10 und
- auf ein Verfahren zur Messung eines elektrischen Stroms oder Magnetfeldes gemäss dem Oberbegriff des Patentanspruchs 11.

Stand der Technik

Ein optischer Stromsensor ist aus EP 0 856 737 A1 bekannt. Er weist eine spulenförmig gewickelte, magnetooptisch aktive Sensorfaser auf, welche einen Stromleiter umschliesst. Mindestens an einem Ende ist die Sensorfaser über ein Phasenverzögerungselement mit einer weiteren optischen Faser, einer sogenannten Zu- beziehungsweise Rückleitungsfaser, verbunden, über welche sich Licht in die Sensorfaser ein- beziehungsweise auskoppeln lässt. Die Zu- beziehungsweise Rückleitungsfasern haben vorzugsweise einen elliptischen Kernquerschnitt. In ihnen propagieren linear polarisierte Lichtwellen. Als Phasenverzögerungselement wirkt ein doppelbrechendes Fasersegment, welches zwischen Sensorfaser und Zuleitungsfaser angeordnet ist. Dieses Fasersegment weist zwei optische Hauptachsen auf, eine schnelle (kurze) und eine langsame (lange) Hauptachse. Diese sind unter 45° zu den zwei Hauptachsen der Zu- beziehungsweise Rückleitungsfasern ausgerichtet. Üblicherweise ist seine Länge so gewählt, dass es als $\lambda/4$-Phasenverzögerungselement wirkt, entsprechend einem Phasenverzögerungswinkel von einem ungeradzahligen Vielfachen von 90°. Dadurch wandelt es die genannten linear polarisierten Lichtwellen der Zu- und Rückleitungsfasern in zirkular polarisierte Lichtwellen um, welche sich in der Sensorfaser ausbreiten. Für den genannten Winkel zwischen den Hauptachsen und für den Phasenverzögerungswinkel des Phasenverzögerungselementes sind in der genannten EP 0 856 737 A1 Toleranzwinkel angegeben.

Die Sensorfaser wird entweder als Sagnac-Interferometer oder, wenn eines ihrer Enden verspiegelt ist, als Reflexions-Interferometer betrieben. In beiden Fällen breiten sich in der Sensorfaser zwei zirkular polarisierte Lichtwellen aus. Die Wellen sind dabei im Falle des Sagnac-Interferometers gegenläufig, im Falle des Reflexions-Interferometers laufen sie in gleicher Richtung. Im Sagnac-Interferometer haben beide Wellen denselben Polarisationssinn, wobei sie entweder links- oder rechts-zirkular polarisiert sind. Im Reflexions-Interferometer weisen sie einen entgegengesetzten Polarisationssinn auf.

Ist der Stromleiter von einem elektrischen Strom I durchflossen, so erzeugt der Strom I ein Magnetfeld, welches zu einer differentiellen Phasenverschiebung zwischen diesen zwei gegenläufigen bzw. gleichlaufenden Lichtwellen führt. Dieser Effekt wird magneto-optischer Effekt oder Farraday-Effekt genannt. Für zirkular polarisierte Lichtwellen in der Sensorfaser ist die entstandene Phasenverschiebung dabei proportional zum Strom und beträgt in der Sagnac-Konfiguration

$$\Delta\phi_S = 2\ \varphi_F$$

und in der Reflexionskonfiguration

$$\Delta\phi_R = 4\ \varphi_F,$$

wobei die sogenannte Faraday-Phasenverschiebung $\varphi_F$ als

$$\varphi_F = V\ N\ I\ ,$$

definiert ist, und wobei V die Verdet-Konstante der Sensorfaser, N die Anzahl der Faserwindungen der Spule und I die Stromstärke bezeichnet.

In der genannten EP 0 856 737 A1 ist eine Sensorfaser beschrieben, die frei von mechanischen Spannungen ist, so dass das erhaltene Mess-Signal nicht von einer temperaturabhängigen, stress-induzierten linearen Doppelbrechung gestört wird. Die Verdet-Konstante V der Sensorfaser weist jedoch ebenfalls eine Temperaturabhängigkeit auf, welche selbst bei einer idealen, stressfreien Faserspule bemerkbar ist.

In EP 1 115 000 ist ein faseroptischer Stromsensor beschrieben, der den Einfluss der Temperaturabhängigkeit der Verdet-Konstanten V dadurch aufhebt, dass ein Phasenverzögerungselement verwendet wird, dessen Temperaturabhängigkeit die Temperaturabhängigkeit der Verdet-Konstanten V kompensiert. Dies wird erreicht, indem das Phasenverzögerungselement einen Phasenverzögerungswinkel aufweist, welcher um einen Winkel $\varepsilon \neq 0°$ von dem Phasenverzögerungswinkel eines idealen Phasenverzögerungselements abweicht. Bei einem $\lambda/4$-Phasenverzögerungselement beträgt der Phasenverzögerungswinkel statt 90° dann 90° + $\varepsilon$, entsprechend Phasenverzögerungswinkeln von typischerweise 95° bis 105°. Je nach Vorzeichen der Temperaturabhängigkeit der Verdet-Konstanten V sind auch negative Winkel $\varepsilon$ möglich.

Derartige Phasenverzögerungselemente werden vorzugsweise als doppelbrechende Fasersegmente mit elliptischem Kernquerschnitt ausgebildet, wobei der Phasenverzögerungswinkel dann durch entsprechende Wahl der Länge des Fasersegments einfach eingestellt werden kann. Werden einem solchen Phasenverzögerungselement mit $\varepsilon \neq 0°$ über die Zuleitungsfaser linear polarisierte Lichtwellen zugeführt, wobei die Hauptachsen der Zuleitungsfaser mit denen des Phasenverzögerungselements einen Winkel von 45° einschliessen, so breiten sich in der Sensorfaser leicht elliptisch polarisierte Lichtwellen aus.

Problematisch bei dieser Art der Kompensation der Temperaturabhängigkeit der Verdet-Konstanten V ist, dass sich durch sie eine Abweichung von einem linearen Zusammenhang zwischen dem zu messenden Strom und einem Mess-Signal ergibt, wobei das Mess-Signal im allgemeinen proportional zu $\Delta\phi_S$ beziehungsweise $\Delta\phi_R$ ist. Das heisst, die für zirkular polarisierte Lichtwellen gültigen linearen Beziehungen $\Delta\phi_S = 2\,V\,N\,I$ und $\Delta\phi_R = 4\,V\,N\,I$ sind für elliptische Lichtwellen nicht mehr gültig. Solche Nichtlinearitäten des Verhältnisses zwischen dem zu messenden Strom und einem Mess-Signal haben typischerweise eine Grössenordnung von 0.1% bis 1% und verursachen Messungenauigkeiten beziehungsweise komplizieren die Auswertung der Messung, sofern eine grössere Messgenauigkeit erforderlich ist. Mit Hilfe einer aufwendigen Signalverarbeitung können solche Nichtlinearitäten kompensiert werden.

Darstellung der Erfindung

Es ist Aufgabe der Erfindung, einen verbesserten Strom- oder Magnetfeld-Sensor der eingangs genannten Art, ein entsprechendes Herstellungsverfahren und ein entsprechendes Messverfahren zu schaffen. Der Sensor soll die oben genannten Nachteile beheben. Insbesondere soll der Sensor eine grössere Messgenauigkeit aufweisen und/oder die Auswertung der Messung vereinfachen und den Einsatz einer aufwendigen Signalverarbeitung erübrigen.

Diese Aufgabe löst ein Verfahren zur Herstellung eines optischen Strom- oder Magnetfeldsensors mit den Merkmalen des Patentanspruchs 1, ein optischer Strom- oder Magnetfeldsensor nach Patentanspruch 10 und ein Verfahren zur Messung eines elektrischen Stroms oder eines Magnetfeldes mit den Merkmalen des Patentanspruches 11.

Der optische Strom- oder Magnetfeldsensor verfügt über einen Sensorkopf mit einem Sensorelement und zwei Phasenverzögerungselementen sowie zwei Lichtleitungselementen. Die Bestandteile des Sensorkopfes sind in der Reihenfolge erstes Lichtleitungselement, erstes Phasenverzögerungselement, Sensorelement, zweites Phasenverzögerungselement, zweites Lichtleitungselement entlang eines Lichtweges angeordnet und optisch miteinander verbunden. Die Phasenverzögerungswinkel $\rho,\rho'$ der Phasenverzögerungselemente weichen um Winkel $\varepsilon,\varepsilon' \neq 0°$ mit $-90° < \varepsilon, \varepsilon' < 90°$ von einem ungeradzahligen Vielfachen von 90° ab. Eine Hauptachse des ersten Lichtleitungselements schliesst mit einer Hauptachse des ihm benachbarten ersten Phasenverzögerungselements einen Winkel von 45° $\pm$ $\Delta\alpha$ mit $\Delta\alpha \neq 0°$ und $0° < \Delta\alpha < 45°$ ein, welcher in Abhängigkeit von den Winkeln $\varepsilon,\varepsilon'$ gewählt wird. Nichtlinearitäten zwischen einem unmittelbaren Mess-Signal und einem zu messenden elektrisehen Strom oder Magnetfeld, die aufgrund von $\varepsilon,\varepsilon' \neq 0°$ resultieren, können durch eine entsprechende $\varepsilon,\varepsilon'$-abhängige Wahl des Winkels $\Delta\alpha$ mindestens annähernd kompensiert werden. Dadurch entsteht ein mindestens annähernd linearer Zusammenhang zwischen dem unmittelbaren Mess-Signal und dem zu messenden elektrischen Strom oder Magnetfeld. Dies hat den Vorteil, eine einfache Auswertung der Messung zu ermöglichen, und eine grössere Messgenauigkeit zu erreichen, ohne eine aufwendige Signalverarbeitung zu benutzen.

In dem erfindungsgemässen Verfahren zur Herstellung eines optischen Strom- oder Magnetfeldsensors werden die genannten Bestandteile des Sensorkopfes in der genannten Weise angeordnet und dimensioniert. Insbesondere wird der genannte Winkel $\Delta\alpha$ in Abhängigkeit von den Winkeln $\varepsilon,\varepsilon'$ gewählt.

Ein in Sagnac-Konfiguration aufgebauter Sensor ist kostengünstig herstellbar, da eine kommerziell erhältliche Detektionseinheit ohne aufwendige Anpassungen eingesetzt werden kann.

In einer vorteilhaften Ausführungsform der Erfindung ist der Winkel $\Delta\alpha$ in Abhängigkeit von $\varepsilon,\varepsilon'$ derart gewählt, dass die genannten Nichtlinearitäten um mindestens eine halbe Grössenordnung, also einen Faktor 3, gegenüber dem Fall $\Delta\alpha = 0°$ verringert sind.

In einer bevorzugten Ausführungsform der Erfindung weisen beide Phasenverzögerungselemente eine von null verschiedene Abweichung $\varepsilon,\varepsilon'$ ihrer Phasenverzögerungswinkel $\rho,\rho'$ von ungeradzahligen Vielfachen von 90° auf, und beide Phasenverzögerungselemente zusammen weisen eine Temperaturabhängigkeit auf, die die Temperaturabhängigkeit der Verdet-Konstanten V des Sensorelementes mindestens annähernd kompensiert. Das heisst, die beiden Phasenverzögerungselemente liefern zusammen einen solchen Beitrag zur Temperaturabhängigkeit des unmittelbaren Mess-Signals, dass die Temperaturabhängigkeit der Verdet-Konstanten V des Sensorelementes mindestens annähernd kompensiert ist. Die aus der Kombination der beiden Phasenverzögerungselemente resultierende Temperaturabhängigkeit ist also in der geschilderten Art gewählt. Auf diese Weise weist der Sensor nicht nur einen mindestens annähernd linearen Zusammenhang zwischen dem unmittelbaren Mess-Signal und dem zu messenden elektrischen Strom oder Magnetfeld auf, sondern auch eine verbesserte Temperaturstabilität.

In einer weiteren bevorzugten Ausführungsform des Erfindungsgegenstandes sind zusätzlich die Phasenverzögerungswinkel $\rho,\rho'$ gleich ($\rho = \rho'$ und $\varepsilon = \varepsilon'$). Und die relative Ausrichtung der Phasenverzögerungselemente zu den mit ihnen jeweils optisch verbundenen Lichtleitungselementen ist gleichartig gewählt, das heisst, dass für beide Phasenverzögerungselemente mindestens eine Hauptachse des Phasenverzögerungselements mit mindestens einer Hauptachse des Lichtleitungselements den gleichen Winkel $\Delta\alpha = \Delta\alpha'$ einschliessen. Durch diesen symmetrischen Aufbau des Sensorkopfes wird eine verbesserte Herstellbarkeit und eine grosse Unempfindlichkeit gegenüber Störeinflüssen erreicht.

Weiterhin ist es vorteilhaft, wenn die Einkopplung der linear polarisierten Lichtwellen in die Phasenverzögerungselemente mittels polarisationserhaltender Fasern als Lichtleitungselemente erfolgt. Dadurch kann die Erzeugung der linear polarisierten Lichtwellen in grosser räumlicher Entfernung von den Phasenverzögerungselementen und dem Sensorelement angeordnet sein, während trotzdem die Einkopplung der linear polarisierten Lichtwellen stets unter demselben Winkel erfolgt.

In einer anderen bevorzugten Ausführungsform des Erfindungsgegenstandes ist mindestens eines der beiden Phasenverzögerungselemente, vorzugsweise beide Phasenverzögerungselemente, als Faserstück mit elliptischem Kern ausgebildet, das einen Phasenverzögerungswinkel von 90°+ $\varepsilon$ (beziehungsweise 90°+ $\varepsilon'$) aufweist. Derartige Phasenverzögerungselemente sind einfach und preisgünstig herstellbar.

Es ist von Vorteil, das Sensorelement so zu wählen, dass es einen Stromleiter spulenförmig umfassen kann, denn so kann die Messgenauigkeit und Empfindlichkeit des Sensors erhöht werden.

Vorteilhaft ist es weiterhin, als Sensorelement eine magnetooptisch aktive Glasfaser einzusetzen, die nahezu frei von mechanischen Spannungen ist. Dadurch wird eine Temperaturabhängigkeit des Sensors reduziert.

Weitere bevorzugte Ausführungsformen gehen aus den Patentansprüchen hervor.

Kurze Beschreibung der Zeichnungen

Im folgenden wird der Erfindungsgegenstand anhand von bevorzugten Ausführungsbeispielen und den beiliegenden Zeichnungen näher erläutert. Es zeigen:

Fig. 1 Schematische Darstellung eines Teils eines erfindungsgemässen Sensors;

Fig. 2 Schematische Darstellung eines erfindungsgemässen Strom- oder Magnetfeldsensors in Sagnac-Konfiguration;

Fig. 3 Schematische Darstellung der Ausbreitungsrichtung von sich im Betrieb eines erfindungsgemässen Strom- oder Magnetfeldsensors im Sensorkopf ausbreitenden Lichtwellen;

Fig. 4 Graphische Darstellung des berechneten Zusammenhangs zwischen der differentiellen Phasenverschiebung $\Delta\phi_S$ (normiert auf 2 $\varphi_F$) und dem Zweifachen der Faraday-Phasenverschiebung $\varphi_F$, 2 $\varphi_F$ = 2 V N I, bei zueinander parallel ausgerichteten schnellen Achsen der Phasenverzögerungselemente ($\chi$=0°) und $\Delta\alpha = \Delta\alpha'$ = 0°, für verschiedene Winkel $\varepsilon$;

Fig. 5 Graphische Darstellung des berechneten Zusammenhangs zwischen der differentiellen Phasenverschiebung $\Delta\phi_S$ (normiert auf 2 $\varphi_F$) und dem Zweifachen der Faraday-Phasenverschiebung $\varphi_F$, 2 $\varphi_F$ = 2 V N I, bei zueinander parallel ausgerichteten schnellen Achsen der Phasenverzögerungselemente ($\chi$=0°) und $\varepsilon$ = 0°, für verschiedene Winkel $\Delta\alpha = \Delta\alpha'$;

Fig. 6 Graphische Darstellung des berechneten Zusammenhangs zwischen der differentiellen Phasenverschiebung $\Delta\phi_S$ (normiert auf 2 $\varphi_F$) und dem Zweifachen der Faraday-Phasenverschiebung $\varphi_F$, 2 $\varphi_F$ = 2 V N I, bei zueinander parallel ausgerichteten schnellen Achsen der Phasenverzögerungselemente ($\chi$=0°) und $\varepsilon$ = 13°, für verschiedene Winkel $\Delta\alpha = \Delta\alpha'$;

Die in den Zeichnungen verwendeten Bezugszeichen und deren Bedeutung sind in der Bezugszeichenliste zusammengefasst aufgelistet. Grundsätzlich sind in den Figuren gleiche Teile mit gleichen Bezugszeichen versehen.

Die beschriebenen Ausführungsbeispiele stehen beispielhaft für den Erfindungsgegenstand und haben keine beschränkende Wirkung.

Wege zur Ausführung der Erfindung

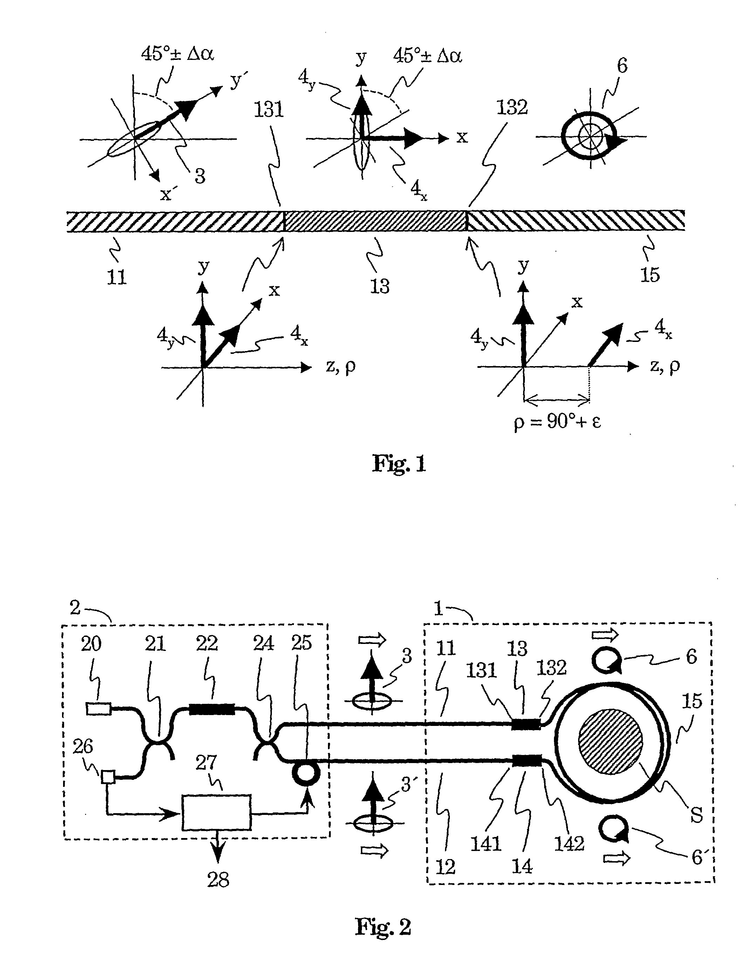

Figur 1 zeigt schematisch einen Teil eines Sensorkopfes 1 für einen optischen Strom- oder Magnetfeldsensor. Ein erstes Lichtleitungselement 11, das als eine polarisationserhaltende optische Faser mit elliptischem Kernquerschnitt ausgebildet ist, ist mit einem ersten Ende 131 eines ersten Phasenverzögerungselementes 13 optisch verbunden, d.h. Lichtwellen können von dem Lichtleitungselement 11 in das erste Ende 131 des ersten Phasenverzögerungselementes 13 eingekoppelt werden und umgekehrt. Als erstes Phasenverzögerungselement 13 wird ein Stück Faser mit elliptischem Kernquerschnitt eingesetzt, dessen Länge derart gewählt ist, dass sein Phasenverzögerungswinkel $\rho$ = 90° + $\varepsilon$ mit einem Winkel $\varepsilon \neq 0°$ beträgt. Aus der eingangs genannten EP 1 115 000 ist bekannt, dass eine geschickte Wahl des Winkels $\varepsilon$ zu einer Verbesserung der Temperaturstabilität eines optischen Stromsensors führen kann. Ein zweites Ende 132 des ersten Phasenverzögerungselementes 13 ist mit einem Sensorelement 15 optisch verbunden, bei welchem es sich vorzugsweise um eine magnetooptisch aktive Faser mit rundem Kernquerschnitt handelt.

In den drei Graphiken im oberen Teil von Figur 1 sind Lichtwellen $3,4_x,4_y,6$, die sich in den drei genannten Fasersegmenten 11,13,15 ausbreiten, sowie bevorzugte Kernquerschnitte und Hauptachsen x,x',y,y' schematisch dargestellt. Die Lichtwellen werden durch dicke Pfeile dargestellt, die die E-Feld-Vektoren der Lichtwellen symbolisieren sollen. In dem ersten Lichtleitungselement 11 breiten sich erste linear polarisierte Lichtwellen 3 aus, die in diesem Fall eine Polarisationsachse y' aufweisen, welche mit der langsamen, langen Hauptachse y' des ersten Lichtleitungselementes 11 zusammenfällt. Die Hauptachse y' des ersten Lichtleitungselementes 11 schliesst mit einer Hauptachse y des ersten Phasenverzögerungselementes 13 einen Winkel von 45° + $\Delta\alpha$ ein, wobei $\Delta\alpha \neq 0°$ ein Winkel ist, der in Abhängigkeit von dem Winkel $\varepsilon$ gewählt wird. Beim Eintritt der ersten linear polarisierten Lichtwellen 3 in das erste Phasenverzögerungselement 13 werden diese zu zweiten linear polarisierten Lichtwellen 4, umfassend zweite linear polarisierte Lichtwellen $4_x$ und zweite linear polarisierte Lichtwellen $4_y$, deren Polarisationsachsen entlang der beiden Hauptachsen x,y des ersten Phasenverzögerungselementes 13 liegen.

Die zwei Graphiken im unteren Teil von Figur 1 stellen die zweiten linear polarisierten Lichtwellen 4 in dem ersten Phasenverzögerungselement 13 schematisch dar. Am ersten Ende 131 des ersten Phasenverzögerungselementes 13 sind die entlang der langsamen Hauptachse y des ersten Phasenverzögerungselementes 13 polarisierten zweiten linear polarisierten Lichtwellen $4_y$ mit den entlang der schnellen Hauptachse x des ersten Phasenverzögerungselementes 13 polarisierten zweiten linear polarisierten Lichtwellen $4_x$ in Phase. Nach Durchlaufen des ersten Phasenverzögerungselementes 13 entlang der Ausbreitungsrichtung z hat sich an dem zweiten Ende 132 des ersten Phasenverzögerungselementes 13 zwischen den Lichtwellen $4_x$ und den Lichtwellen $4_y$ der Phasenunterschied $\rho$ = 90° + $\varepsilon$ akkumuliert.

Durch die Einkopplung der zweiten linear polarisierten Lichtwellen 4 in das Sensorelement 15 an dem zweiten Ende 132 des Phasenverzögerungselementes 13 entstehen dort elliptisch polarisierte Lichtwellen 6, die sich dann in dem Sensorelement 15 ausbreiten.

Figur 2 zeigt einen erfindungsgemässen Strom- oder Magnetfeldsensor, der eine Sagnac-Konfiguration aufweist. Auf den grundsätzlichen Aufbau und auf die Funktionsweise des Sensors wird hier nicht in Detail eingegangen. Dem eingangs zitierten Stand der Technik können entsprechende Informationen entnommen werden. Neben dem Sensorkopf 1 verfügt der Strom- oder Magnetfeldsensor noch über eine Sende-Auswerte-Einheit 2. Diese umfasst im dargestellten Beispiel eine Lichtquelle 20, einen Faserkoppler 21, einen Faserpolarisator 22, einen zweiten Faserkoppler 24 und einen Phasenmodulator 25, sowie einen Detektor 26, einen Signalprozessor 27 und eine Messwert-Ausgabe 28. Die Sende-Auswerte-Einheit 2 dient der Erzeugung und Detektion von Licht sowie der Auswertung und Ausgabe von Messdaten.

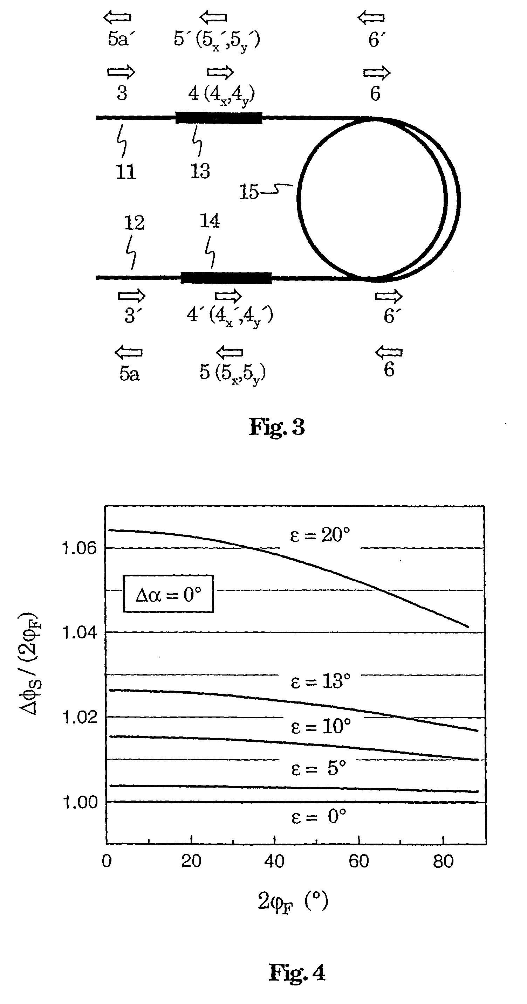

In Figur 3 sind die Ausbreitungsrichtungen der im Betrieb des in Figur 2 gezeigten Strom- oder Magnetfeldsensors im Sensorkopf 1 ausbreitungsfähigen Lichtwellen dargestellt. Die offenen Pfeile über den Bezugszeichen geben die Ausbreitungsrichtung an. In Figur 2 sind aus Gründen der Übersichtlichkeit nur wenige der Lichtwellen und Ausbreitungsrichtungen dargestellt. Für die folgenden Erläuterungen wird auf die Figuren 2 und 3 verwiesen.

Über das erste Lichtleitungselement 11 und ein zweites Lichtleitungselement 12 oder entprechende Verlängerungen oder Verbindungen ist die Sende-Auswerte-Einheit 2 mit dem Sensorkopf 1 verbunden. Letzterer weist neben dem ersten Phasenverzögerungselement 13 noch ein zweites Phasenverzögerungselement 14 auf, welches analog zu dem ersten Phasenverzögerungselement 13 an einem ersten Ende 141 mit dem zweiten Lichtleitungselement 12 optisch verbunden ist, und an einem zweiten Ende 142 mit einem zweiten Ende des Sensorelements 15 optisch verbunden ist. Das Sensorelement 15 ist als magnetooptisch aktive Faser ausgebildet, die spulenförmig einen Stromleiter S umschliesst. Die Lichtleitungselemente 11 und 12 sind als polarisationserhaltende Fasern mit elliptischem Kernquerschnitt ausgebildet.

In der Sende-Auswerte-Einheit 2 wird linear polarisiertes Licht erzeugt, aus welchen dann in den beiden Lichtleitungselementen 11 und 12 die ersten linear polarisierten Lichtwellen 3 bzw. 3' werden. Die Graphiken in der Mitte der Figur 2 symbolisieren diese Lichtwellen 3,3' als dicke Pfeile. Die offenen Pfeile geben die Ausbreitungsrichtung der Lichtwellen 3,3' an.

Die ersten linear polarisierten Lichtwellen 3 aus dem ersten Lichtleitungselement 11 werden, wie im Zusammenhang mit Figur 1 beschrieben, mittels des (ersten) Phasenverzögerungselements 13 in elliptisch polarisierte Lichtwellen 6 umgewandelt, die dann in dem Sensorelement 15 propagieren. Dabei schliesst eine Hauptachse des ersten Lichtleitungselements 11 mit einer Hauptachse des ersten Phasenverzögerungselementes 13 den genannten Winkel $45° + \Delta\alpha$ ein, und der Phasenverzögerungswinkel $\rho$ des ersten Phasenverzögerungselementes 13 beträgt die genannten $\rho = 90° + \varepsilon$.

Wird der Stromleiter S von einem elektrischen Strom I durchflossen, so erfahren die elliptisch polarisierten Lichtwellen 6 durch den Faraday-Effekt eine magnetooptisch induzierte Phasenverschiebung. Nach Durchlaufen der Sensorfaser koppeln die elliptisch polarisierten Lichtwellen 6 in das zweite Ende 142 des zweiten Phasenverzögerungselementes 14 ein, in welchem sie in dritte linear polarisierte Lichtwellen 5, umfassend linear polarisierte Lichtwellen $5_x$ und $5_y$, umgewandelt werden. Diese dritten linear polarisierten Lichtwellen 5 regen in dem zweiten Lichtleitungselement 12 vierte linear polarisierte Lichtwellen 5a an, welche dann über das zweite Lichtleitungselement 12 der Sende-Auswerte-Einheit 2 zugeführt werden. Dort werden die Lichtwellen detektiert. Dritte Lichtwellen 5a, deren Polarisationsachse senkrecht zu der Polarisationsachse der ersten linear polarisierten Lichtwellen 3 ausgerichtet sind, können in dem Faserpolarisator 22 blockiert werden, so dass sie nicht detektiert werden.

Analog verhält es sich mit den ersten linear polarisierten Lichtwellen 3' in dem zweiten Lichtleitungselement 12. Die daraus entstehenden Lichtwellen sind mit gestrichenen Bezugszeichen versehen. Die ersten linear polarisierten Lichtwellen 3' werden mittels des zweiten Phasenverzögerungselements 14 in elliptisch polarisierte Lichtwellen 6' umgewandelt, die dann in dem Sensorelement 15 propagieren, und zwar mit einer Propagationsrichtung, die der der elliptisch polarisierten Lichtwellen 6 entgegengesetzt ist. Dabei schliesst eine Hauptachse des zweiten Lichtleitungselements 12 mit einer Hauptachse des zweiten Phasenverzögerungselementes 14 einen Winkel $45° + \Delta\alpha'$ ein, mit einem Winkel $\Delta\alpha'$, für den $0° \leq \Delta\alpha' < 45°$ gilt. Das zweite Phasenverzögerungselement 14 weist einen Phasenverzögerungswinkel $\rho'$ auf der um einen Winkel $\varepsilon'$ von 90° verschieden ist, das heisst $\rho' = 90° + \varepsilon'$. Es gilt $\varepsilon' \neq 0°$.

Ein Magnetfeld, das aufgrund eines in dem Stromleiter S fliessenden elektrischen Stroms I entsteht, verursacht über den Faraday-Effekt eine magnetooptisch induzierte Phasenverschiebung der elliptisch polarisierten Lichtwellen 6'. Nach Durchlaufen des Sensorelements 15 koppeln die elliptisch polarisierten Lichtwellen 6' in das zweite Ende 132 des ersten Phasenverzögerungselementes 13 ein. Es werden dritte linear polarisierte Lichtwellen 5' erzeugt, welche dritte linear polarisierte Lichtwellen $5_x'$ und $5_y'$ umfassen, und es findet eine Phasenverschiebung um $90° + \varepsilon$ zwischen diesen dritten linear polarisierten Lichtwellen $5_x'$ und $5_y'$ statt. Danach entstehen an dem ersten Ende 131 des ersten Phasenverzögerungselementes 13 vierte linear polarisierte Lichtwellen 5a', die dann über das erste Lichtleitungselement 11 der Sende-Auswerte-Einheit 2 zugeführt werden. In dieser werden die Lichtwellen detektiert, und die magnetooptisch induzierte Phasenverschiebung wird bestimmt. Dritte Lichtwellen 5a', deren Polarisationsachse senkrecht zu der Polarisationsachse der ersten linear polarisierten Lichtwellen 3' ausgerichtet sind, können in dem Faserpolarisator 22 blockiert werden, so dass sie nicht detektiert werden. Die magnetooptisch induzierte Phasenverschiebung aus den elliptisch polarisierten Lichtwellen 6 oder die aus den in dem Sensorelement 15 sich gegenläufig ausbreitenden elliptisch polarisierten Lichtwellen 6' kann als ein unmittelbares Mess-Signal zur Bestimmung des elektrischen Stroms I dienen. Die Bezeichnung "unmittelbares" Mess-Signal soll bedeuten, dass keine Signal-Aufbereitung stattgefunden hat, um aus dem Mess-Signal ein mindesten annähernd zum elektrischen Strom I proportionales Signal zu erzeugen.

Zur einfachen Bestimmung der magnetooptisch induzierten Phasenverschiebung wird in einem Sensor in Sagnac-Konfiguration vorzugsweise das Signal der einen elliptisch polarisierten Lichtwellen 6 als Referenz-Signal für die anderen gegenläufigen elliptisch polarisierten Lichtwellen 6' benutzt. Als unmittelbares Mess-Signal wird dann eine differentielle Phasenverschiebung $\Delta\Phi_S$ der beiden elliptisch polarisierten Lichtwellen 6 und 6' genommen. Dieses unmittelbare Mess-Signal ist genau doppelt so gross wie die magnetooptisch induzierte Phasenverschiebung, die jede der elliptisch polarisierten Lichtwellen 6 und 6' einzeln erfährt. In dem aus EP 0 856 737 A1 bekannten Fall $\varepsilon = 0°$, $\varepsilon' = 0°$, $\Delta\alpha = 0°$, $\Delta\alpha' = 0°$ beläuft sich dieses unmittelbare Mess-Signal dann auf das Doppelte der Faraday-Phasenverschiebung $\varphi_F$, $2\varphi_F = 2 V N I$, und ist somit proportional zu dem elektrischen Strom I.

Wenn, wie in der genannten EP 1 115 000, $\varepsilon \neq 0°$ und $\varepsilon' \neq 0°$ ist, aber $\Delta\alpha = 0°$ und $\Delta\alpha' = 0°$, so ist der Zusammenhang zwischen dem unmittelbaren Mess-Signal und dem elektrischen Strom I nicht mehr linear. Beschreibt man die Propagation der elliptisch polarisierten Lichtwellen 6,6' mit Hilfe von Jones-Matrizen und leitet man ihre differentielle Phasenverschiebung $\Delta\Phi_S$ aus den komplexen Amplituden der beiden im Detektor 26 in der Sende-Auswerte-Einheit 2 miteinander interferierenden Lichtwellen ab, so erhält man für das unmittelbare Mess-Signal $\Delta\phi_S$

$$\Delta\phi_S = \arctan\frac{(\cos\varepsilon + \cos\varepsilon')\sin(2\varphi_F)}{(1 + \cos\varepsilon\,\cos\varepsilon')\cos(2\varphi_F) - \sin\varepsilon\,\sin\varepsilon'\,\cos(2\chi)}$$

Dabei ist $\chi$ der Winkel zwischen den schnellen Achsen der beiden Phasenverzögerungselemente 13 und 14. Für den Spezialfall $\chi = 0°$ und $\varepsilon = \varepsilon'$ ergibt dies für kleine Faraday-Phasenverschiebungen $\varphi_F$ näherungsweise $\Delta\phi_S = 2\varphi_F/\cos\varepsilon$, was für kleine Winkel $\varepsilon$ als $\Delta\phi_S = 2\varphi_F (1 + \varepsilon^2/2)$ genähert werden kann. Für den Spezialfall $\chi = 90°$ und $\varepsilon = \varepsilon'$ ergibt dies für kleine $\varphi_F$ näherungsweise $\Delta\phi_S = 2\varphi_F\cos\varepsilon$, was für kleine Winkel $\varepsilon$ als $\Delta\phi_S = 2\varphi_F (1-\varepsilon^2/2)$ genähert werden kann.

Für $\varepsilon = \varepsilon' = 13°$ und $\chi = 0°$ beträgt die relative Abweichung von der Linearität des Verhältnisses zwischen dem unmittelbaren Mess-Signal $\Delta\phi_S$ und dem zu messenden elektrischen Strom I etwa -0.21% bei $2\varphi_F = 40°$ und -0.92% bei $2\varphi_F = 90°$. So weit wurde noch $\Delta\alpha = 0°$ und $\Delta\alpha' = 0°$ angenommen, d.h. die Hauptachsen der Lichtleitungselemente 11 und 12 schliessen mit den Hauptachsen der Phasenverzögerungselemente 13 beziehungsweise 14 jeweils einen Winkel von genau 45° ein.

Wenn, entsprechend dem erfindungsgemässen Fall, $\varepsilon, \varepsilon' \neq 0°$ ist, und zusätzlich $\Delta\alpha \neq 0°$ und/oder $\Delta\alpha' \neq 0°$ gewählt wird, so lautet der Zusammenhang zwischen dem unmittelbaren Mess-Signal $\Delta\phi_S$ und der zum elektrischen Strom I proportionalen Faraday-Phasenverschiebung $\varphi_F$

$$\Delta\phi_S = \arctan\frac{\llcorner(\cos\varepsilon\,\cos(2\Delta\alpha) + \cos\varepsilon'\,\cos(2\Delta\alpha')\lrcorner\sin(2\varphi_F)}{A_1\cos(2\varphi_F) + A_2\cos(2\chi) - A_3\sin(2\chi)}$$

mit

$$A_1 = 1 + \cos\varepsilon\,\cos\varepsilon'\,\cos(2\Delta\alpha)\,\cos(2\Delta\alpha')$$

$$A_2 = \sin(2\Delta\alpha)\,\sin(2\Delta\alpha') - \sin\varepsilon\,\sin\varepsilon'\,\cos(2\Delta\alpha)\,\cos(2\Delta\alpha')$$

$$A_3 = \sin\varepsilon\,\cos(2\Delta\alpha)\,\sin(2\Delta\alpha') + \sin\varepsilon'\,\cos(2\Delta\alpha')\,\sin(2\Delta\alpha)$$

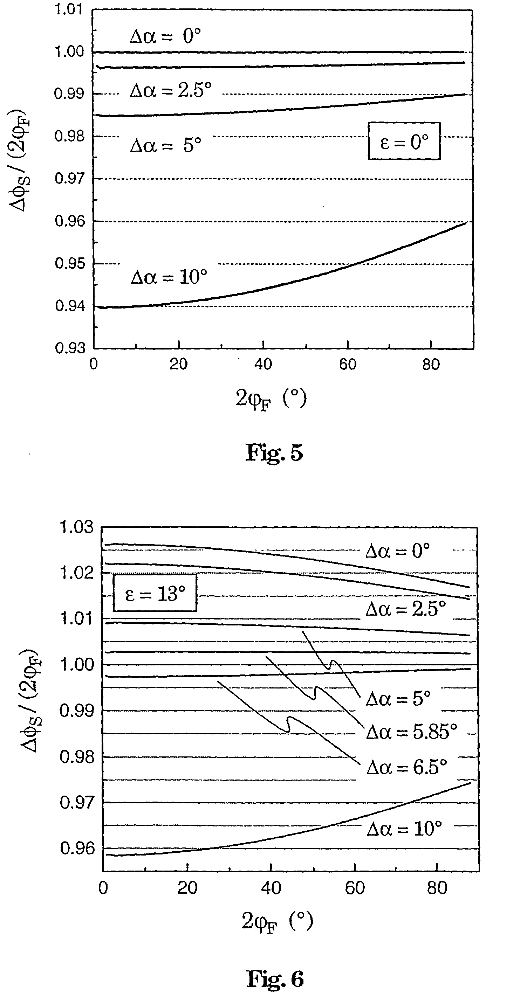

Durch die Wahl der Winkel $\Delta\alpha$ und $\Delta\alpha'$ kann also, wie auch in Fig. 6 gezeigt ersichtlich, das nicht-lineare Verhältnis zwischen dem unmittelbaren Mess-Signal $\Delta\phi_S$ und dem elektrischen Strom 1 beeinflusst werden, so dass die Nichtlinearität verringert wird. Eine geschickte Wahl der Winkel $\Delta\alpha$ und $\Delta\alpha'$ in Abhängigkeit von den Winkeln $\varepsilon$ und $\varepsilon'$ erlaubt es, diese aus $\varepsilon \neq 0°$ und $\varepsilon' \neq 0°$ resultierende Nichtlinearität mindestens annähernd zu kompensieren. Dann liegt ein mindestens annähernd lineares Verhältnis zwischen dem unmittelbaren Mess-Signal $\Delta\phi_S$ und dem elektrischen Strom I vor. Im allgemeinen lässt sich die Nichtlinearität um mindestens eine halbe Grössenordnung, also einen Faktor 3, verringern gegenüber dem Fall $\Delta\alpha = \Delta\alpha' = 0°$. Eine im mathematischen Sinne vollständige Kompensation der Nichtlinearität ist wegen der Unterschiedlichkeit der funktionalen Zusammenhänge für die Winkel $\varepsilon$, $\varepsilon'$ und für die Winkel $\Delta\alpha$, $\Delta\alpha'$ nicht möglich. Aber die Nichtlinearität kann so weit reduziert und kompensiert werden, dass sie für die Praxis bedeutungslos ist.

Der obigen Gleichung kann entnommen werden, dass die Vorzeichen der Winkel $\Delta\alpha$ und $\Delta\alpha'$ unerheblich sind, da sie sich bezüglich dieser Vorzeichen symmetrisch verhält. Nur die Beträge der Winkel $\Delta\alpha$ und $\Delta\alpha'$ sind von Bedeutung. Ein Beispiel, wie die Winkel für eine mindestens annähernde Kompensation berechnet werden, wird im folgenden für eine Sensor-Konfiguration gegeben, bei welcher die schnellen Achsen der Phasenverzögerungselemente 13,14 parallel zueinander ausgerichtet sind, also $\chi=0°$.

Figur 4 gibt für $\chi=0°$, $\Delta\alpha = \Delta\alpha' = 0°$ und verschiedene Winkel $\varepsilon = \varepsilon'$ den gemäss obiger Gleichung berechneten Zusammenhang zwischen dem unmittelbaren Mess-Signal $\Delta\phi_S$ und dem Zweifachen des Faraday-Phasenverzögerungswinkels, $2\varphi_F$, an. $\Delta\phi_S$ ist dabei auf $2\varphi_F$ normiert.

Deutlich ist zu erkennen, dass die Nichtlinearität für grössere Winkel $\varepsilon$ zunimmt. Die Grösse der Nichtlinearitäten liegt im Promille- bis Prozentbereich. Für $\varepsilon = 13°$ beträgt die relative Nichtlinearität -0.21% bei $2\varphi_F = 40°$ und -0.92% bei $2\varphi_F = 90°$. Diese Nichtlinearitäten berechnet man gemäss

$$\{\Delta\phi_S/(2\varphi_F)[2\varphi_F = 40°] - \Delta\phi_S/(2\varphi_F)[2\varphi_F = 0°]\} / \Delta\phi_S/(2\varphi_F)[2\varphi_F = 0°]$$

bzw.

$$\{\Delta\phi_S/(2\phi_F)[2\phi_F = 90°] - \Delta\phi_S/(2\phi_F)[2\phi_F = 0°]\} / \Delta\phi_S/(2\phi_F)[2\phi_F = 0°],$$

also aus der Differenz von $\Delta\phi_S/(2\phi_F)$ bei $2\phi_F = 40°$ beziehungsweise $2\phi_F = 90°$ und $\Delta\phi_S/(2\phi_F)$ bei $2\phi_F = 0°$, normiert mit $\Delta\phi_S/(2\phi_F)$ bei $2\phi_F = 0°$.

Figur 5 gibt für den Fall $\varepsilon = \varepsilon' = 0°$ für verschiedene Winkel $\Delta\alpha = \Delta\alpha'$ den gemäss obiger Gleichung für $\chi=0°$ berechneten Zusammenhang zwischen dem unmittelbaren Mess-Signal $\Delta\phi_S$ und dem Zweifachen des Faraday-Phasenverzögerungswinkels, $2\Delta\phi_S$, an. $\Delta\phi_S$ ist dabei auf $2\phi_F$ normiert. Deutlich ist zu erkennen, dass die Nichtlinearität für grössere Winkel $\Delta\alpha$ zunimmt. Die Grösse der Nichtlinearitäten liegt im Promille-Bereich. Es fällt auf, dass die Krümmung der Kurven in Figur 5 der Krümmung der Kurven in Figur 4 entgegengesetzt ist. Dies eröffnet die Möglichkeit der genannten erfindungsgemässen Kompensation von auf $\varepsilon \neq 0°$ und/oder $\varepsilon' \neq 0°$ zurückzuführenden Nichtlinearitäten durch geschickte Wahl der Winkel $\Delta\alpha$, $\Delta\alpha'$.

Figur 6 gibt für den Fall $\varepsilon = \varepsilon' = 13°$ und $\chi=0°$ für verschiedene Winkel $\Delta\alpha = \Delta\alpha'$ den gemäss obiger Gleichung berechneten Zusammenhang zwischen dem unmittelbaren Mess-Signal $\Delta\phi_S$ und dem Zweifachen des Faraday-Phasenverzögerungswinkels, $2\Delta\phi_S$, an. $\Delta\phi_S$ ist dabei auf $2\phi_F$ normiert. Deutlich ist zu erkennen, dass für Winkel $\Delta\alpha$ um $5.85°$ die auf $\varepsilon \neq 0°$ zurückzuführende Nichtlinearität mindestens annähernd kompensiert ist. Auf diese Weise kann der erfindungsgemässe Winkel $\Delta\alpha$ graphisch ermittelt werden.

Eine Berechnung von $\Delta\alpha$ in Abhängigkeit von $\varepsilon$ ist aber zu bevorzugen. Bei einem gegebenen Phasenverzögerungswinkel $\rho=\rho'$, also einem gegebenen Winkel $\varepsilon=\varepsilon'$, lässt sich der erfindungsgemässe Winkel $\Delta\alpha=\Delta\alpha'$ wie folgt mit Hilfe der oben angegebenen Gleichung berechnen:

In der Praxis soll die Funktion $\Delta\phi_S(\varepsilon=\varepsilon', \Delta\alpha=\Delta\alpha', \phi_F)/2\phi_F$ insbesondere für Werte von $2\phi_F$ zwischen $0°$ und $90°$ unabhängig von $2\phi_F$ sein. Der dafür zu wählende Winkel $\Delta\alpha = \Delta\alpha'$ ergibt sich aus

$$\Delta\phi_S(\varepsilon, \Delta\alpha=\Delta\alpha', \phi_F=0°)/(2\phi_F) = \Delta\phi_S(\varepsilon, \Delta\alpha=\Delta\alpha', \phi_F=90°)/(2\phi_F)$$

Diese Gleichung kann man numerisch lösen. Alternativ erhält man für $\chi = 0°$ und kleine Winkel $\varepsilon$ auch den folgenden analytischen Ausdruck:

$$\sin^2(2\Delta\alpha) \approx \sin^2 \varepsilon - 2 [(\pi-1)/(\pi-2)] \sin^4 \varepsilon + ...$$

Terme höherer Ordnung sind hier weggelassen. Hieraus ergibt sich als Näherungslösung für $\Delta\alpha = \Delta\alpha'$

$$\Delta\alpha \approx \pm(1/2) \arcsin \{\sin^2 \varepsilon - 2 [(\pi-1)/(\pi-2)] \sin^4 \varepsilon\}^{1/2}$$

Für $\varepsilon = 13°$ findet man mittels dieser Gleichung $\Delta\alpha = \pm 5.85°$ (vergleiche auch Figur 6). In diesem Fall variiert das Verhältnis $\Delta\phi_S/2\phi_F$ zwischen $2\phi_F=0°$ und $2\phi_F=90°$ um weniger als $0.02\%$. Es variiert also um fast einen Faktor 50 und somit um mehr als anderthalb Grössenordnungen weniger ist als die oben genannten $0.92\%$ im Falle $\Delta\alpha = \Delta\alpha' = 0°$. Falls eine noch weitergehende Linearisierung erwünscht wird, so kann mittels eines iterativen Verfahrens diese Variation in einem vorgegebenen Wertebereich der Variablen $2\phi_F$, zum Beispiel zwischen $2\phi_F = 0°$ und $2\phi_F = 90°$, minimiert werden. Für $\varepsilon =13°$ erhält man dann $\Delta\alpha = \pm 5.9°$ als optimalen Winkel. Das Vorgehen im Falle eines Sensors mit $\chi \neq 0°$ ist völlig analog. Von besonderem Interesse ist der Fall orthogonal zueinander ausgerichteter schneller Achsen der Phasenverzögerungselemente 13,14, also $\chi = 90°$. Für $\chi = 90°$ ergibt sich bei sonst unveränderten Parametern für eine optimale Kompensation der Nichtlinearitäten $\Delta\alpha = \Delta\alpha' = \pm 6.8°$.

Neben den im Zusammenhang mit der Figur 2 diskutierten Ausführungsbeispielen sind zahlreiche andere Varianten möglich. Die Lichtleitelemente 11, 12 können auch als andere Typen polariationserhaltender optischer Fasern ausgebildet sein, wie beispielsweise sogenannten Panda-Fasern, Bowtie-Fasern oder Fasern mit einem zusätzlichen, inneren, elliptischen Cladding (Fasermantel). Alternativ ist auch denkbar, die ersten linear polarisierten Lichtwellen 3,3' direkt oder mittels einer Linse oder einer optischen Baugruppe in die Phasenverzögerungselemente 13,14 einzuleiten. Dann wären die Lichtleitungselemente 11,12 Luft oder Vakuum, oder die Linse oder die optische Baugruppe. Als Hauptachsen der Lichtleitungselemente 11,12 werden stets die Achsen bezeichnet, die durch die Polarisationsvektoren der ersten linear polarisierten Lichtwellen 3,3' gegeben sind.

Die optischen Verbindungen zwischen den Phasenverzögerungselementen 13,14 und den Lichtleitungselementen 11,12 beziehungsweise dem Sensorelement 15 können direkte Verbindungen sein, wie sie beispielsweise durch Zusammenschweissen mittels eines sogenannten Splice-Geräts erstellt werden. Oder es sind Verbindungen über ein Zwischenmedium, beispielsweise ein Gel, Klebstoff oder ein Faserstück oder eine optische Baugruppe. Oder die Einkopplung von Lichtwellen findet durch ein Vakuum oder durch ein Gas statt.

Die Phasenverzögerungselemente 13,14 können optische Faserstücke sein mit geometrisch induzierter Doppelbrechung, zum Beispiel durch einen elliptischen Kern, oder mit spannungsinduzierter Doppelbrechung, wie beispielsweise Bowtie- oder Panda-Fasern oder Fasern mit einem innerem elliptischen Mantel. Sie können auch als Schlaufen gewöhnlicher Einmoden-Fasern mit rundem Kern ausgebildet sein. Hier wird die Phasenverzögerung über die Doppelbrechung erzeugt, welche durch die Faserkrümmung hervorgerufen wird. Weiterhin sind auch $\lambda/4$-Plättchen denkbar. Die Phasenverzögerungswinkel $\rho,\rho'$ können um Winkel $\varepsilon,\varepsilon'$ von einem beliebigen ungeradzahligen Vielfachen von 90° abweichen. Die Winkel $\varepsilon,\varepsilon'$ sind vorzugsweise dadurch vorgegeben, dass sie gerade so gross sind, dass die Temperaturabhängigkeit der Verdet-Konstanten des Sensorelementes 15 durch die Temperaturabhängigkeit der Phasenverzögerungselemente 13,14 kompensiert wird. Dies kann positive wie auch negative Winkel $\varepsilon,\varepsilon'$ zur Folge haben.

Die Winkel $\varepsilon$ und $\varepsilon'$ können verschieden gross sein. Weiterhin gibt es für einen gegebenen Winkel $\chi$ im allgemeinen viele verschiedene Paare von Winkeln $\Delta\alpha, \Delta\alpha'$, die zu einer mindestens annähernden Kompensation der aus $\varepsilon \neq 0°$ und/oder $\varepsilon' \neq 0°$ resultierenden Nichtlinearitäten führen. Trotzdem ist die Wahl von $\Delta\alpha$ dann noch abhängig von $\varepsilon$, aber $\Delta\alpha$ hängt dann zusätzlich von $\varepsilon'$ und $\Delta\alpha'$ sowie von $\chi$ ab. Man kann auch sagen, dass $\Delta\alpha$ und $\Delta\alpha'$ in Abhängigkeit von mindestens den Winkeln $\varepsilon$ und $\varepsilon'$ gewählt werden. Der Winkel $\chi$ kommt noch als Einflussgrösse hinzu.

Das Sensorelement 15 kann, wie oben angegeben spulenförmig, vorzugsweise in mehreren Windungen, den Stromleiter S umfassen. Es sind aber auch Bruchteile einer Windung möglich, und es können auch anders gekrümmte oder ungekrümmte Sensorelemente 15 eingesetzt werden. Vorzugsweise besteht das Sensorelement 15 aus einer optischen Faser, die frei von mechanischen Spannungen ist, wie es in EP 0 856 737 A1 beschrieben ist. Besonders vorteilhaft ist der Einsatz einer solchen spannungsfreien Sensorfaser 15 zusammen mit einem temperaturabhängigkeitskompensierenden Phasenverzögerungselement 13, 14, wie es in EP 1 115 000 beschrieben ist. Ein derartiger erfindungsgemässer Strom- oder Magnetfeldsensor weist praktisch keine Temperaturabhängigkeit auf, hat aber ein lineares Verhältnis zwischen einem zu messenden Strom I und dem unmittelbaren Mess-Signal $\Delta\Phi_S$.

Ausser magnetooptisch aktiven Fasern sind auch massive Gläser oder magnetooptische Kristalle, wie beispielsweise Yttrium-Eisen-Granat, $Y_3 Fe_5 O_{12}$, als Sensorelement 15 einsetzbar. Speziell, wenn der Strom- oder Magnetfeldsensor zur lokalen Messung von Magnetfeldern eingesetzt wird, sind diese Varianten vorteilhaft. Das Sensorelement 15 muss mit dem zu messenden Magnetfeld wirkverbunden sein, vorzugsweise an einem Ort, an dem das Magnetfeld gross ist, so dass die elliptisch polarisierten Lichtwellen 6,6' aufgrund des Magnetfeldes eine möglichst grosse magnetooptisch induzierte Phasenverschiebung erfahren. Es ist fernerhin auch möglich, mehrere Sensorelemente 15 in einem Sensorkopf 1 einzusetzen.

Für die Winkel $\varepsilon$, $\varepsilon'$ und $\Delta\alpha$, $\Delta\alpha'$ gelten die Bedingungen $0° < \varepsilon$, $\varepsilon' < 90°$ und $0° < \Delta\alpha,\Delta\alpha' < 45°$, wobei gegebenenfalls auch $\Delta\alpha' = 0°$ und/oder $\varepsilon' = 0$ sein kann. Da, wie oben dargelegt, das Vorzeichen von $\Delta\alpha$ keine Rolle spielt, kann man sich auf positive $\Delta\alpha$ beschränken. Werden $\varepsilon$, $\varepsilon'$ für die oben genannte Temperaturkompensation gewählt, so ergeben sich aufgrund der heute erhältlichen Fasermaterialien Werte von bis zu etwa 20° für $\varepsilon$, $\varepsilon'$ bei $\varepsilon = \varepsilon'$ und $\chi = 0°$ oder $\chi = 90°$. Somit kommen vorzugsweise Winkel $\varepsilon$ kleiner als etwa 30° vor. Für solche $\varepsilon$ ergeben sich Winkel $\Delta\alpha$ von bis zu etwa 10°. Wie oben erwähnt, ist es bei $\Delta\alpha \neq \Delta\alpha'$ möglich, verschiedene Paare $\Delta\alpha,\Delta\alpha'$ erfindungsgemäss zu wählen, so dass bei $\varepsilon \approx 30°$ auch erfindungsgemässe Winkel $\Delta\alpha$ grösser als 10° möglich sind.

Als Sende-Auswerte-Einheit 2 sind interferometrisch wie auch polarimetrisch detektierende Varianten möglich. Aus dem Stand der Technik sind verschiedene Möglichkeiten zur Auswertung der unmittelbaren Mess-Signale bekannt. In dem Beispiel aus Figur 2 wurden jeweils die einen elliptisch polarisierten Lichtwellen 6 als Referenzsignal für die anderen elliptisch polarisierten Lichtwellen 6' genutzt, wobei beide dem Einfluss des elektrischen Stroms I oder des Magnetfeldes ausgesetzt waren. Es ist aber auch möglich, die magnetooptisch induzierte Phasenverschiebung zu messen, ohne voneinander verschiedene elliptisch polarisierte Lichtwellen 6 und 6' einzusetzen. Beispielsweise können innerhalb der Sende-Auswerte-Einheit 2 linear polarisierte Lichtwellen erzeugt werden, die keine magnetooptisch induzierte Phasenverschiebung erleiden, und gegenüber denen sich die magnetooptisch induzierten Phasenverschiebungen der elliptisch polarisierten Lichtwellen 6 oder 6' bestimmen lassen.

Als Lichtquelle 20 wird typischerweise eine niederkohärente Halbleiterquelle eingesetzt, wie beispielsweise eine Superluminiszenzdiode, eine Multimode-Laserdiode, eine unterhalb der Laserschwelle betriebene Laserdiode, oder eine Luminiszenzdiode (LED), vorzugsweise mit Wellenlängen um etwa 800 nm, 1300 nm oder 1550 nm. Aber verschiedenste Wellenlängen, zum Beispiel aus dem ultravioletten, dem sichtbaren oder dem infraroten Bereich sind einsetzbar.

Bei der Herstellung eines Sensorkopfes werden also die Winkel $\Delta\alpha,\Delta\alpha'$ in Abhängigkeit von den Winkeln $\varepsilon$, $\varepsilon'$ derart gewählt, dass die genannten Nichtlinearitäten deutlich verringert oder sogar mindestens annähernd kompensiert werden. Dies kann beispielsweise in einer der oben beschriebenen Arten geschehen. Man kann darum auch von einem definierten Winkel $\Delta\alpha$ sprechen, der erfindungsgemäss gewählt wird. Dies grenzt ihn klar von zufällig zustandekommenden, beispielsweise toleranzbedingten Winkeln $\Delta\alpha$ ab, die vorzugsweise so klein wie möglich, also etwa 0° sind. Bei der Durchführung der Erfindung ist es unerheblich, ob, beispielsweise aufgrund von Fertigungstoleranzen, ein vom optimalen Winkel $\Delta\alpha$ leicht abweichender Winkel realisiert wird. Wesentlich ist, dass ein definierter Winkel $\Delta\alpha$ unter der Massgabe gewählt wird, die genannten Nichtlinearitäten zu verringern, und dass ein entsprechendes Ergebnis erzielt wird.

Bezugszeichenliste

| | |
|---|---|
| 1 | Sensorkopf |
| 11 | erstes Lichtleitungselement |
| 12 | zweites Lichtleitungselement |
| 13 | erstes Phasenverzögerungselement |
| 131 | erstes Ende des ersten Phasenverzögerungselements |
| 132 | zweites Ende des ersten Phasenverzögerungselements |
| 14 | zweites Phasenverzögerungselement |
| 141 | erstes Ende des zweiten Phasenverzögerungselements |
| 142 | zweites Ende des zweiten Phasenverzögerungselements |
| 15 | Sensorelement |
| 2 | Sende-Auswerte-Einheit |
| 20 | Lichtquelle |
| 21 | Faserkoppler |
| 22 | Faserpolarisator |
| 24 | zweiter Faserkoppler |
| 25 | Phasenmodulator |
| 26 | Detektor |
| 27 | Signalprozessor |
| 28 | Messwert-Ausgabe |
| 3, 3' | erste linear polarisierte Lichtwellen |
| $4,4_x,4_y,4',4_x',4_y'$ | zweite linear polarisierte Lichtwellen |
| 5, 5' | dritte linear polarisierte Lichtwellen |
| 5a, 5a' | vierte linear polarisierte Lichtwellen |
| 6, 6' | elliptisch polarisierte Lichtwellen |

| | |
|---|---|
| I | elektrischer Strom, Stromstärke |
| N | Anzahl Windungen |
| S | Stromleiter |
| V | Verdet-Konstante |
| $\Delta\alpha$ | Winkel, um den der Einkopplungswinkel in das (erste) Phasenverzögerungselement von 45° abweicht |
| $\Delta\alpha'$ | Winkel, um den der Einkopplungswinkel in das (zweite) Phasenverzögerungselement von 45° abweicht |
| $\Delta\phi_S$ | differentielle Phasenverschiebung bei Sagnac-Konfiguration, unmittelbares Mess-Signal bei Sagnac-Konfiguration |
| $\varepsilon$ | Winkel, um den der Phasenverzögerungswinkel $\rho$ des (ersten) Phasenverzögerungselements von einem ungeradzahligen Vielfachen von 90° abweicht |
| $\varepsilon'$ | Winkel, um den der Phasenverzögerungswinkel $\rho'$ des (zweiten) Phasenverzögerungselements von einem ungeradzahligen Vielfachen von 90° abweicht |
| $\varphi_F$ | Faraday-Phasenverschiebung, $\varphi_F = V N I$ |
| $\rho$ | Phasenverzögerungswinkel des (ersten) Phasenverzögerungselements |
| $\rho'$ | Phasenverzögerungswinkel des (zweiten) Phasenverzögerungselements |
| $\chi$ | Winkel |

**Patentansprüche**

1. Verfahren zur Herstellung eines optischen Strom- oder Magnetfeldsensors, der eine Sende-Auswerte-Einheit (2) und einen Sensorkopf (1) umfasst, wobei von der Sende-Auswerte-Einheit (2) Licht einer Wellenlänge $\lambda$ erzeugbar ist, und wobei der Sensorkopf (1) ein erstes Lichtleitungselement (11), ein zweites Lichtleitungselement (12), ein erstes Phasenverzögerungselement (13), ein zweites Phasenverzögerungselement (14) und ein Sensorelement (15) umfasst, wobei jedes der beiden Lichtleitungselemente (11,12) jeweils mindestens eine Hauptachse (x',y') aufweist, wobei jedes der beiden Phasenverzögerungselemente (13,14) jeweils mindestens eine Hauptachse (x, y) aufweist, wobei elliptisch polarisierte Lichtwellen (6;6') in dem Sensorelement (15) ausbreitungsfähig sind, welche aufgrund eines zu messenden elektrischen Stroms oder Magnetfeldes eine magnetooptisch induzierte Phasenverschiebung erfahren,

wobei ein erstes Ende (131) des ersten Phasenverzögerungselements (13) mit dem ersten Lichtleitungselement (11) optisch verbunden wird, und ein zweites Ende (132) des ersten Phasenverzögerungselements (13) mit einem ersten Ende des Sensorelements (15) optisch verbunden wird,

wobei ein erstes Ende (141) des zweiten Phasenverzögerungselements (14) mit dem zweiten Lichtleitungselement (12) optisch verbunden wird, und ein zweites Ende (142) des zweiten Phasenverzögerungselements (14) mit einem zweiten Ende des Sensorelements (15) optisch verbunden wird,

wobei die Sende-Auswerte-Einheit (2) mit dem ersten Lichtleitungselement (11) und mit dem zweiten Lichtleitungselement (12) optisch verbunden wird,

wobei das erste Phasenverzögerungselement (13) derart dimensioniert wird, dass sein Phasenverzögerungswinkel $\rho$ um einen Winkel $\varepsilon$ mit $\varepsilon \neq 0°$ und $-90° < \varepsilon < 90°$ von einem ungeradzahligen Vielfachen von 90° abweicht, und wobei das zweite Phasenverzögerungselement (14) derart dimensioniert wird, dass sein Phasenverzögerungswinkel $\rho'$ um einen Winkel $\varepsilon'$ mit $\varepsilon' \neq 0°$ und $-90° < \varepsilon' < 90°$ von einem ungeradzahligen Vielfachen von 90° abweicht, und

wobei das erste Lichtleitungselement (11) relativ zu dem ersten Phasenverzögerungselement (13) derart angeordnet wird, dass die mindestens eine Hauptachse (x',y') des ersten Lichtleitungselements (11) mit der mindestens einen Hauptachse (x,y) des ersten Phasenverzögerungselements (13) einen Winkel einschliesst, der um einen Winkel $\Delta\alpha$ von 45° abweicht,

**dadurch gekennzeichnet,**

**dass** für den Winkel $\Delta\alpha$ gilt: $0° < \Delta\alpha < 45°$, und dass der Winkel $\Delta\alpha$ in Abhängigkeit von mindestens den Winkeln $\varepsilon$ und $\varepsilon'$ derart gewählt wird, dass Nichtlinearitäten des Verhältnisses zwischen der magnetooptisch induzierten Phasenverschiebung der elliptisch polarisierten Lichtwellen (6;6') und dem zu messenden elektrischen Strom oder Magnetfeld, die bei einer Strom- oder Magnetfeldmessung mittels des optischen Strom- oder Magnetfeldsensors auftreten, gegenüber dem Fall $\Delta\alpha = 0°$ verringert sind.

2. Herstellungsverfahren nach Anspruch 1, **dadurch gekennzeichnet,**
   **dass** der Winkel $\Delta\alpha$ in Abhängigkeit von mindestens dem Winkel $\varepsilon$ derart gewählt wird, dass die Nichtlinearitäten des Verhältnisses zwischen der magnetooptisch induzierten Phasenverschiebung der elliptisch polarisierte Lichtwellen (6;6') und dem zu messenden elektrischen Strom oder Magnetfeld, die bei einer Strom- oder Magnetfeldmessung mittels des optischen Strom- oder Magnetfeldsensors auftreten, um mindestens einen Faktor 3 gegenüber dem Fall $\Delta\alpha = 0°$ verringert sind.

3. Herstellungsverfahren nach Anspruch 1, **dadurch gekennzeichnet,**
   **dass** Phasenverzögerungselemente (13,14) eingesetzt werden, die zusammen eine Temperaturabhängigkeit aufweisen, die eine Temperaturabhängigkeit einer Verdet-Konstanten des Sensorelementes (15) mindestens annähernd kompensiert.

4. Herstellungsverfahren nach Anspruch 3, **dadurch gekennzeichnet,**
   **dass** die beiden Phasenverzögerungselemente (13,14) derart dimensioniert werden, dass ihre Phasenverzögerungswinkel $\rho,\rho'$ gleich sind, und
   **dass** das zweite Lichtleitungselement (12) relativ zu dem zweiten Phasenverzögerungselement (14) derart angeordnet wird, dass die mindestens eine Hauptachse (x',y') des zweiten Lichtleitungsetements (12) mit der mindestens einen Hauptachse (x,y) des zweiten Phasenverzögerungselements (14) einen Winkel einschliesst, der um einen Winkel $\Delta\alpha'$ mit $0° < \Delta\alpha' < 45°$ von 45° abweicht, und
   **dass** die Winkel $\Delta\alpha$ und $\Delta\alpha'$ gleich gross gewählt werden.

5. Herstellungsverfahren nach Anspruch 1, **dadurch gekennzeichnet,**
   **dass** als Lichtleitungselemente (11,12) polarisationserhaltende Fasern eingesetzt werden, und dass diese mit den Phasenverzögerungselementen (13,14) verbunden werden.

6. Herstellungsverfahren nach Anspruch 1, **dadurch gekennzeichnet,**
   **dass** als mindestens eines der beiden Phasenverzögerungselemente (13,14) ein Stück Faser mit elliptischem Kern eingesetzt wird, das derart dimensioniert wird, dass sein Phasenverzögerungswinkel $\rho,\rho'$ um den Winkel $\varepsilon, \varepsilon'$ von 90° abweicht.

7. Herstellungsverfahren nach Anspruch 1, **dadurch gekennzeichnet,**
**dass** ein Sensorelement (15) eingesetzt wird, das so angeordnet werden kann, dass es einen Stromleiter (S) spulenförmig umfasst.

8. Herstellungsverfahren nach Anspruch 7, **dadurch gekennzeichnet,**
**dass** als das Sensorelement (15) eine magnetooptisch aktive Faser mit rundem Kernquerschnitt eingesetzt wird, die nahezu frei von mechanischen Spannungen ist.

9. Herstellungsverfahren nach Anspruch 1, **dadurch gekennzeichnet,**
**dass** der Betrag des Winkels ε kleiner als 30° gewählt wird, und dass der Winkel Δα kleiner als 10° gewählt wird.

10. Optischer Strom- oder Magnetfeldsensor, umfassend eine Sende-Auswerte-Einheit (2) und einen Sensorkopf (1), wobei von der Sende-Auswerte-Einheit (2) Licht einer Wellenlänge λ erzeugbar ist, und wobei der Sensorkopf (1) ein erstes Lichtleitungselement (11), ein zweites Lichtleitungselement (12), ein erstes Phasenverzögerungselement (13), ein zweites Phasenverzögerungselement (14) und ein Sensorelement (15) umfasst, wobei jedes der beiden Lichtleitungselemente (11, 12) jeweils mindestens eine Hauptachse (x',y') aufweist, wobei jedes der beiden Phasenverzögerungselemente (13,14) jeweils mindestens eine Hauptachse (x,y) aufweist, wobei elliptisch polarisierte Lichtwellen (6;6') in dem Sensorelement (15) ausbreitungsfähig sind, welche aufgrund eines zu messenden elektrischen Stroms oder Magnetfeldes eine magnetooptisch induzierte Phasenverschiebung erfahren, wobei ein erstes Ende (131) des ersten Phasenverzögerungselements (13) mit dem ersten Lichtleitungselement (11) optisch verbunden ist, und ein zweites Ende (132) des ersten Phasenverzögerungselements (13) mit einem ersten Ende des Sensorelements (15) optisch verbunden ist, wobei ein erstes Ende (141) des zweiten Phasenverzögerungselements (14) mit dem zweiten Lichtleitungselement (12) optisch verbunden ist, und ein zweites Ende (142) des zweiten Phasenverzögerungselements (14) mit einem zweiten Ende des Sensorelements (15) optisch verbunden ist, wobei die Sende-Auswerte-Einheit (2) mit dem ersten Lichtleitungselement (11) und mit dem zweiten Lichtleitungselement (12) optisch verbunden ist,
wobei das erste Phasenverzögerungselement (13) derart dimensioniert ist, dass sein Phasenverzögerungswinkel ρ um einen Winkel ε mit ε ≠ 0° und -90° < ε < 90° von einem ungeradzahligen Vielfachen von 90° abweicht, wobei das zweite Phasenverzögerungselement (14) derart dimensioniert ist, dass sein Phasenverzögerungswinkel ρ' um einen Winkel ε' mit ε' ≠ 0° und -90° < ε' < 90° von einem ungeradzahligen Vielfachen von 90° abweicht, und wobei das erste Lichtleitungselement (11) relativ zu dem ersten Phasenverzögerungselement (13) derart angeordnet ist, dass die mindestens eine Hauptachse (x',y') des ersten Lichtleitungselements (11) mit der mindestens einen Hauptachse (x,y) des ersten Phasenverzögerungselements (13) einen Winkel einschliesst, der um einen Winkel Δα von 45° abweicht,
**dadurch gekennzeichnet,**
**dass** für den Winkel Δα gilt: 0° < Δα < 45°, und dass der Winkel Δα in Abhängigkeit von mindestens den Winkeln ε,ε' derart gewählt ist, dass Nichtlinearitäten des Verhältnisses zwischen der magnetooptisch induzierten Phasenverschiebung der elliptisch polarisierten Lichtwellen (6;6') und dem zu messenden elektrischen Strom oder Magnetfeld, die bei einer Strom- oder Magnetfeldmessung mittels des optischen Strom- oder Magnetfeldsensors auftreten, gegenüber dem Fall Δα = 0° um mindestens einen Faktor 3 verringert sind.

11. Verfahren zur Messung eines elektrischen Stroms oder eines Magnetfeldes, wobei in einer Sende-Auswerte-Einheit (2) erste linear polarisierte Lichtwellen (3) erzeugt werden, welche in ein erstes Ende (131) eines ersten Phasenverzögerungselements (13) eingekoppelt werden,
wobei durch die ersten linear polarisierten Lichtwellen (3) in dem ersten Phasenverzögerungselement (13) zweite linear polarisierte Lichtwellen ($4;4_x,4_y$) angeregt werden, welche das erste Phasenverzögerungselement (13) durchlaufen und dadurch zueinander eine Phasenverschiebung um einen Winkel ρ erfahren,
wobei die zweiten linear polarisierten Lichtwellen ($4;4_x,4_y$) in einem mit seinem ersten Ende mit einem zweiten Ende (132) des ersten Phasenverzögerungselements (13) verbundenen Sensorelement (15) elliptisch polarisierte Lichtwellen (6) anregen, welche durch den elektrischen Strom (I) oder das Magnetfeld eine magnetooptisch induzierte Phasenverschiebung erfahren,
wobei die elliptisch polarisierten Lichtwellen (6) danach in ein mit seinem zweiten Ende (142) mit einem zweiten Ende des Sensorelementes (15) verbundenes zweites Phasenverzögerungselement (14) eingekoppelt werden,
wobei durch die elliptisch polarisierten Lichtwellen (6) in dem zweiten Phasenverzögerungselement (14) dritte linear polarisierte Lichtwellen ($5;5_x,5_y$) angeregt werden, welche das zweite Phasenverzögerungselement (14) durchlaufen und dadurch zueinander eine Phasenverschiebung um einen Winkel ρ' erfahren,
wobei die dritten linear polarisierten Lichtwellen ($5;5_x,5_y$) aus einem ersten Ende (141) des zweiten Phasenverzögerungselementes (14) ausgekoppelt werden und vierte linear polarisierte Lichtwellen (5a) anregen, welche vierten linear polarisierten Lichtwellen (5a) der Sende-Auswerte-Einheit (2) zugeführt werden,

wobei in der Sende-Auswerte-Einheit (2) die vierten linear polarisierten Lichtwellen (5a) detektiert und Messdaten ausgewertet werden,

wobei der Winkel ρ um einen Winkel ε mit ε ≠ 0° und -90° < ε < 90° von einem ungeradzahligen Vielfachen von 90° abweicht, und wobei der Winkel ρ' um einen Winkel ε' mit ε' ≠ 0° und -90° < ε' < 90° von einem ungeradzahligen Vielfachen von 90° abweicht, und

wobei eine Polarisationsachse (x',y') der ersten linear polarisierten Lichtwellen (3) relativ zu einer Polarisationsache (x,y) der zweiten linear polarisierten Lichtwellen (4) und/oder eine Polarisationsachse (x,y) der dritten linear polarisierten Lichtwellen (5) relativ zu einer Polarisationsache (x',y') der vierten linear polarisierten Lichtwellen (5a) derart angeordnet wird, dass die entsprechenden Polarisationsachsen einen Winkel einschliessen, der um einen Winkel Δα von 45° abweicht,

**dadurch gekennzeichnet,**

**dass** für den Winkel Δα gilt: 0° < Δα < 45° von 45°, und

**dass** der Winkel Δα derart in Abhängigkeit von mindestens den Winkeln ε,ε' gewählt wird, dass Nichtlinearitäten des Verhältnisses zwischen der magnetooptisch induzierten Phasenverschiebung der elliptisch polarisierten Lichtwellen (6;6') und dem zu messenden elektrischen Strom (I) oder Magnetfeld gegenüber dem Fall Δα = 0° verringert sind.

## Claims

1. Method for production of an optical current or magnetic field sensor, which comprises a transmission evaluation unit (2) and a sensor head (1), in which case the transmission evaluation unit (2) can produce light at a wavelength λ, and in which case the sensor head (1) comprises a first optical fibre element (11), a second optical fibre element (12), a first phase delay element (13), a second phase delay element (14) and a sensor element (15), in which case each of the two optical fibre elements (11, 12) each has at least one major axis (x', y'), in which case each of the two phase delay elements (13, 14) each has at least one major axis (x, y), and in which case elliptically polarized light waves (6; 6') can propagate in the sensor element (15) and are subjected to a magnetooptically induced phase shift as a result of an electric current or magnetic field to be measured,

   with a first end (131) of the first phase delay element (13) being optically connected to the first optical fibre element (11), and a second end (132) of the first phase delay element (13) being optically connected to a first end of the sensor element (15),

   with a first end (141) of the second phase delay element (14) being optically connected to the second optical fibre element (12), and a second end (142) of the second phase delay element (14) being optically connected to a second end of the sensor element (15),

   with the transmission evaluation unit (2) being optically connected to the first optical fibre element (11) and to the second optical fibre element (12),

   with the first phase delay element (13) being designed such that its phase delay angle p differs from an odd-numbered multiple of 90° by an angle ε where ε ≠ 0° and -90° < ε < 90°, and

   with the second phase delay element (14) being designed such that its phase delay angle ρ' differs from an odd-numbered multiple of 90° by an angle ε' where ε' ≠ 0° and -90° < ε' < 90°, and

   with the first optical fibre element (11) being arranged relative to the first phase delay element (13) such that the at least one major axis (x', y') of the first optical fibre element (11) includes an angle which differs from 45° by an angle Δα with the at least one major axis (x, y) of the first phase delay element (13),

   **characterized**

   **in that** the angle Δα is defined by: 0° < Δα < 45° and in that the angle Δα is chosen as a function of at least the angles ε and ε' such that any non-linearities in the relationship between the magnetooptically induced phase shift of the elliptically polarized light waves (6; 6') and the electric current or magnetic field to be measured, which occur when the current or magnetic field is measured by means of the optical current or magnetic field sensor, are less than in the situation Δα = 0°.

2. Production method according to claim 1, **characterized**

   **in that** the angle Δα is chosen as a function of at least the angle ε such that the non-linearities in the relationship between the magnetooptically induced phase shift of the elliptically polarized light waves (6; 6') and the electric current or magnetic field to be measured, which occur when the current or magnetic field is measured by means of the optical current or magnetic field sensor, are reduced by a factor of at least 3 in comparison to the situation Δα = 0°.

**3.** Production method according to Claim 1,
**characterized**
**in that** phase delay elements (13, 14) are used which together have a temperature dependency which at least approximately compensates for any temperature dependency of a Verdet constant of the sensor element (15).

**4.** Production method according to Claim 3,
**characterized**
**in that** the two phase delay elements (13, 14) are designed such that their phase delay angles p, p' are the same, and in that the second optical fibre element (12) is arranged relative to the second phase delay element (14) such that the at least one major axis (x', y') of the second optical fibre element (12) includes an angle which differs from 45° by an angle $\Delta\alpha'$, where $0° < \Delta\alpha' < 45°$, with the at least one major axis (x, y) of the second phase delay element (14), and
**in that** the angles $\Delta\alpha$ and $\Delta\alpha'$ are chosen to be the same.

**5.** Production method according to Claim 1,
**characterized**
**in that** polarization-maintaining fibres are used as the optical fibre elements (11, 12), and in that these are connected to the phase delay elements (13, 14).

**6.** Production method according to Claim 1,
**characterized**
**in that** a piece of fibre with an elliptical core is used as at least one of the two phase delay elements (13, 14) and is designed such that its phase delay angle $\rho$, $\rho'$ differs from 90° by the angle $\varepsilon$, $\varepsilon'$.

**7.** Production method according to Claim 1,
**characterized**
**in that** a sensor element (15) is used which can be arranged such that it has an electrical conductor (S) in the form of a coil.

**8.** Production method according to Claim 7,
**characterized**
**in that** a magnetooptically active fibre which has a round core cross section and is virtually free of mechanical stresses is used as the sensor element (15).

**9.** Production method according to Claim 1,
**characterized**
**in that** the magnitude of the angle $\varepsilon$ is chosen to be less than 30°, and in that the angle $\Delta\alpha$ is chosen to be less than 10°.

**10.** Optical current or magnetic field sensor, comprising a transmission evaluation unit (2) and a sensor head (1), in which case the transmission evaluation unit (2) can produce light at a wavelength $\lambda$, and in which case the sensor head (1) comprises a first optical fibre element (11), a second optical fibre element (12), a first phase delay element (13), a second phase delay element (14) and a sensor element (15), in which case each of the two optical fibre elements (11, 12) each has at least one major axis (x', y'), in which case each of the two phase delay elements (13, 14) each has at least one major axis (x, y), and in which case elliptically polarized light waves (6; 6') can propagate in the sensor element (15) and are subjected to a magnetooptically induced phase shift as a result of an electric current or magnetic field to be measured, with a first end (131) of the first phase delay element (13) being optically connected to the first optical fibre element (11), and a second end (132) of the first phase delay element (13) being optically connected to a first end of the sensor element (15), with a first end (141) of the second phase delay element (14) being optically connected to the second optical fibre element (12), and a second end (142) of the second phase delay element (14) being optically connected to a second end of the sensor element (15), with the transmission evaluation unit (2) being optically connected to the first optical fibre element (11) and to the second optical fibre element (12),
with the first phase delay element (13) being designed such that its phase delay angle $\rho$ differs from an odd-numbered multiple of 90° by an angle $\varepsilon$ where $\varepsilon \neq 0°$ and $-90° < \varepsilon < 90°$, and with the second phase delay element (14) being designed such that its phase delay angle p' differs from an odd-numbered multiple of 90° by an angle $\varepsilon'$ where $\varepsilon' \neq 0°$ and $-90° < \varepsilon' < 90°$, and
with the first optical fibre element (11) being arranged relative to the first phase delay element (13) such that the at least one major axis (x', y') of the first optical fibre element (11) includes an angle which differs from 45° by an angle Δα with the at least one major axis (x, y) of the first phase delay element (13),

**characterized**

**in that** the angle Δα is defined by: 0° < Δα < 45° and in that the angle Δα is chosen as a function of at least the angles ε, ε' such that any non-linearities in the relationship between the magnetooptically induced phase shift of the elliptically polarized light waves (6; 6') and the electric current or magnetic field to be measured, which occur when the current or magnetic field is measured by means of the optical current or magnetic field sensor, are reduced by a factor of at least 3 in comparison to the situation Δα = 0°.

11. Method for measurement of an electric current or a magnetic field, with first linearly polarized light waves (3) being produced in a transmission evaluation unit (2) and being injected into a first end (131) of a first phase delay element (13),

with the first linearly polarized light waves (3) exciting second linearly polarized light waves (4; $4_x$, $4_y$) in the first phase delay element (13), which pass through the first phase delay element (13) and in consequence are subject to a phase shift through an angle ρ with respect to one another,

with the second linearly polarized light waves (4; $4_x$, $4_y$) stimulating elliptically polarized light waves (6) in a sensor element (15) whose first end is connected to a second end (132) of the first phase delay element (13), which elliptically polarized light waves (6) are subjected to a magnetooptically induced phase shift produced by the electric current (I) or the magnetic field,

with the elliptically polarized light waves (6) then being injected into a second phase delay element (14), whose second end (142) is connected to a second end of the sensor element (15),

with the elliptically polarized light waves (6) exciting third linearly polarized light waves (5; $5_x$, $5_y$) in the second phase delay element (14), which pass through the second phase delay element (14) and in consequence are subjected to a phase shift through an angle ρ' with respect to one another,

with the third linearly polarized light waves (5; $5_x$, $5_y$) being emitted from a first end (141) of the second phase delay element (14) and exciting fourth linearly polarized light waves (5a) which are supplied to the transmission evaluation unit (2),

with the fourth linearly polarized light waves (5a) being detected, and the measured data being evaluated, in the transmission evaluation unit (2),

with the angle ρ differing from an odd-numbered multiple of 90° by an angle ε, where ε ≠ 0° and -90° < ε < 90°, and with the angle ρ' differing from an odd-numbered multiple of 90° by an angle ε', where ε' ≠ 0° and -90 < ε' < 90° and

with a polarization axis (x', y') of the first linearly polarized light waves (3) being arranged relative to a polarized axis (x, y) of the second linearly polarized light waves (4), and/or a polarization axis (x, y) of the third linearly polarized light waves (5) being arranged relative to a polarization axis (x', y') of the fourth linearly polarized light waves (5a) such that the corresponding polarization axes include an angle which differs from 45° by an angle Δα,

**characterized**

**in that** the angle Δα is defined by: 0° < Δα < 45° and in that the angle Δα is chosen as a function of at least the angles ε, ε' such that any non-linearities in the relationship between the magnetooptically induced phase shift of the elliptically polarized light waves (6; 6') and the electric current (I) or magnetic field to be measured, are less than in the situation Δα = 0°.

**Revendications**

1. Procédé en vue de la fabrication d'un capteur électrique ou de champ magnétique optique qui comprend une unité d'envoi-évaluation (2) et une tête de capteur (1), de la lumière d'une longueur d'onde λ pouvant être produite par l'unité d'envoi-évaluation (2) et la tête de capteur (1) comprenant un premier élément de conduction de la lumière (11), un deuxième élément de conduction de la lumière (12), un premier élément à retard de phase (13), un deuxième élément à retard de phase (14) et un élément de capteur (15), chacun des deux éléments de conduction de la lumière (11, 12) présentant à chaque fois au moins un axe principal (x', y'), chacun des deux éléments à retard de phase (13, 14) présentant à chaque fois au moins un axe principal (x, y), des ondes lumineuses polarisées de manière elliptique (6 ; 6') pouvant se propager dans l'élément de capteur (15), lesquelles subissent en raison d'un courant électrique ou champ magnétique à mesurer un décalage de phase induit de manière magnéto-optique,

une première extrémité (131) du premier élément à retard de phase (13) étant reliée de manière optique au premier élément de conduction de la lumière (11) et une deuxième extrémité (132) du premier élément à retard de phase (13) étant reliée de manière optique à une première extrémité de l'élément de capteur (15),

une première extrémité (141) du deuxième élément à retard de phase (14) étant reliée de manière optique au deuxième élément de conduction de la lumière (12) et une deuxième extrémité (142) du deuxième élément à retard de phase (14) étant reliée de manière optique à une deuxième extrémité de l'élément de capteur (15),

l'unité d'envoi-évaluation (2) étant reliée de manière optique au premier élément de conduction de la lumière (11) et au deuxième élément de conduction de la lumière (12),

le premier élément à retard de phase (13) étant dimensionné de sorte que son angle de retard de phase ρ dévie d'un angle ε avec ε ≠ 0° et -90° < ε < 90° d'un multiple impair de 90°, et

le deuxième élément à retard de phase (14) étant dimensionné de sorte que son angle de retard de phase ρ' dévie d'un angle ε' avec ε' ≠ 0° et -90° < ε' < 90° d'un multiple impair de 90°, et

le premier élément de conduction de la lumière (11) étant disposé par rapport au premier élément à retard de phase (13) de sorte que l'au moins un axe principal (x', y') du premier élément de conduction de la lumière (11) comprend avec l'au moins un axe principal (x, y) du premier élément à retard de phase (13) un angle qui dévie d'un angle $\Delta\alpha$ de 45°,

**caractérisé en ce que**

pour l'angle $\Delta\alpha$, il est valable : 0° < $\Delta\alpha$ < 45° et que l'angle $\Delta\alpha$ est choisi en fonction d'au moins les angles ε et ε' de sorte que des non-linéarités du rapport entre le décalage de phase induit de manière magnéto-optique des ondes lumineuses polarisées de manière elliptique (6 ; 6') et le courant électrique ou champ magnétique à mesurer qui apparaissent lors d'une mesure de courant ou de champ magnétique au moyen du capteur électrique ou de champ magnétique optique soient réduites par rapport au cas où $\Delta\alpha$ = 0°.

2. Procédé de fabrication selon la revendication 1,
**caractérisé en ce que**
l'angle $\Delta\alpha$ est choisi en fonction d'au moins l'angle ε de sorte que les non-linéarités du rapport entre le décalage de phase induit de manière magnéto-optique des ondes lumineuses polarisées de manière elliptique (6 ; 6') et le courant électrique ou champ magnétique à mesurer qui apparaissent lors d'une mesure de courant ou de champ magnétique au moyen du capteur électrique ou de champ magnétique optique soient réduites d'au moins un facteur 3 par rapport au cas où $\Delta\alpha$ = 0°.

3. Procédé de fabrication selon la revendication 1,
**caractérisé en ce que**
des éléments à retard de phase (13, 14) qui présentent ensemble une dépendance à la température qui compense au moins approximativement une dépendance à la température d'une constante de Verdet de l'élément de capteur (15) sont utilisés.

4. Procédé de fabrication selon la revendication 3,
**caractérisé en ce que**
les deux éléments à retard de phase (13, 14) sont dimensionnés de sorte que leurs angles de retard de phase ρ, ρ' soient égaux et que le deuxième élément de conduction de la lumière (12) est disposé par rapport au deuxième élément à retard de phase (14) de sorte que l'au moins un axe principal (x', y') du deuxième élément de conduction de la lumière (12) comprend avec l'au moins un axe principal (x, y) du deuxième élément à retard de phase (14) un angle qui dévie d'un angle $\Delta\alpha$' avec 0° < $\Delta\alpha$' < 45° de 45°, et
que les angles $\Delta\alpha$ et $\Delta\alpha$' sont choisis de taille égale.

5. Procédé de fabrication selon la revendication 1,
**caractérisé en ce que**
des fibres obtenant une polarisation sont utilisées en tant qu'éléments de conduction de la lumière (11, 12) et **en ce que** celles-ci sont reliées aux éléments à retard de phase (13, 14).

6. Procédé de fabrication selon la revendication 1,
**caractérisé en ce que**
un morceau de fibre avec un noyau elliptique qui est dimensionné de sorte que son angle de retard de phase ρ, ρ' dévie de l'angle ε, ε' de 90° est utilisé en tant qu'au moins l'un des deux éléments à retard de phase (13, 14).

7. Procédé de fabrication selon la revendication 1,
**caractérisé en ce que**
un élément de capteur (15) qui peut être disposé de sorte qu'il entoure un conducteur de courant (S) en forme de bobine est utilisé.

8. Procédé de fabrication selon la revendication 7,

**caractérisé en ce que**
une fibre active du point de vue magnéto-optique avec une section transversale ronde qui est pratiquement exempte de tensions mécaniques est utilisée en tant que l'élément de capteur (15).

**9.** Procédé de fabrication selon la revendication 1,
**caractérisé en ce que**
le montant de l'angle ε est choisi inférieur à 30° et **en ce que** l'angle Δα est choisi inférieur à 10°.

**10.** Capteur électrique ou de champ magnétique optique, comprenant une unité d'envoi-évaluation (2) et une tête de capteur (1), de la lumière d'une longueur d'onde λ pouvant être produite par l'unité d'envoi-évaluation (2) et la tête de capteur (1) comprenant un premier élément de conduction de la lumière (11), un deuxième élément de conduction de la lumière (12), un premier élément à retard de phase (13), un deuxième élément à retard de phase (14) et un élément de capteur (15), chacun des deux éléments de conduction de la lumière (11, 12) présentant à chaque fois au moins un axe principal (x', y'), chacun des deux éléments à retard de phase (13, 14) présentant à chaque fois au moins un axe principal (x, y), des ondes lumineuses polarisées de manière elliptique (6 ; 6') pouvant se propager dans l'élément de capteur (15), lesquelles subissent en raison d'un courant électrique ou champ magnétique à mesurer un décalage de phase induit de manière magnéto-optique, une première extrémité (131) du premier élément à retard de phase (13) étant reliée de manière optique au premier élément de conduction de la lumière (11) et une deuxième extrémité (132) du premier élément à retard de phase (13) étant reliée de manière optique à une première extrémité de l'élément de capteur (15), une première extrémité (141) du deuxième élément à retard de phase (14) étant reliée de manière optique au deuxième élément de conduction de la lumière (12) et une deuxième extrémité (142) du deuxième élément à retard de phase (14) étant reliée de manière optique à une deuxième extrémité de l'élément de capteur (15), l'unité d'envoi-évaluation (2) étant reliée de manière optique au premier élément de conduction de la lumière (11) et au deuxième élément de conduction de la lumière (12) ,
le premier élément à retard de phase (13) étant dimensionné de sorte que son angle de retard de phase ρ dévie d'un angle ε avec ε ≠ 0° et -90° < ε < 90° d'un multiple impair de 90°, le deuxième élément à retard de phase (14) étant dimensionné de sorte que son angle de retard de phase ρ' dévie d'un angle ε' avec ε' ≠ 0° et -90° < ε' < 90° d'un multiple impair de 90°, et
le premier élément de conduction de la lumière (11) étant disposé par rapport au premier élément à retard de phase (13) de sorte que l'au moins un axe principal (x', y') du premier élément de conduction de la lumière (11) comprend avec l'au moins un axe principal (x, y) du premier élément à retard de phase (13) un angle qui dévie d'un angle Δα de 45°,
**caractérisé en ce que**
pour l'angle Δα, il est valable : 0° < Δα < 45° et que l'angle Δα est choisi en fonction d'au moins les angles ε, ε' de sorte que des non-linéarités du rapport entre le décalage de phase induit de manière magnéto-optique des ondes lumineuses polarisées de manière elliptique (6 ; 6') et le courant électrique ou champ magnétique à mesurer qui apparaissent lors d'une mesure de courant ou de champ magnétique au moyen du capteur électrique ou de champ magnétique optique soient réduites d'au moins un facteur 3 par rapport au cas où Δα = 0°.

**11.** Procédé en vue de la mesure d'un courant électrique ou d'un champ magnétique, des premières ondes lumineuses polarisées de manière linéaire (3) qui sont alimentées dans une première extrémité (131) d'un premier élément à retard de phase (13) étant produites dans une unité d'envoi-évaluation (2),
des deuxièmes ondes lumineuses polarisées de manière linéaire (4 ; $4_x$, $4_y$) qui passent par le premier élément à retard de phase (13) et subissent ainsi un décalage de phase les unes par rapport aux autres d'un angle ρ étant excitées par les premières ondes lumineuses polarisées de manière linéaire (3) dans le premier élément à retard de phase (13),
les deuxièmes ondes lumineuses polarisées de manière linéaire (4 ; $4_x$, $4_y$) qui subissent par le courant électrique (I) ou le champ magnétique un décalage de phase induit de manière magnéto-optique excitant des ondes lumineuses polarisées de manière elliptique (6) dans un élément de capteur (15) relié avec sa première extrémité à une deuxième extrémité (132) du premier élément à retard de phase (13),
les ondes lumineuses polarisées de manière elliptique (6) étant ensuite alimentées dans un deuxième élément à retard de phase (14) relié avec sa deuxième extrémité (142) à une deuxième extrémité de l'élément de capteur (15),
des troisièmes ondes lumineuses polarisées de manière linéaire (5 ; $5_x$, $5_y$) qui passent par le deuxième élément à retard de phase (14) et subissent ainsi un décalage de phase les unes par rapport aux autres d'un angle ρ' étant excitées par les ondes lumineuses polarisées de manière elliptique (6) dans le deuxième élément à retard de phase (14),
les troisièmes ondes lumineuses polarisées de manière linéaire (5 ; $5_x$, $5_y$) étant découplées d'une première extrémité (141) du deuxième élément à retard de phase (14) et excitant des quatrièmes ondes lumineuses polarisées de manière linéaire (5a) qui sont amenées à l'unité d'envoi-évaluation (2),

les quatrièmes ondes lumineuses polarisées de manière linéaire (5a) étant détectées dans l'unité d'envoi-évaluation (2) et des données de mesure étant évaluées,

l'angle ρ déviant d'un angle ε avec ε ≠ 0° et -90° < ε < 90° d'un multiple impair de 90° et l'angle ρ' déviant d'un angle ε' avec ε' ≠ 0° et -90° < ε' < 90° d'un multiple impair de 90°, et

un axe de polarisation (x', y') des premières ondes lumineuses polarisées de manière linéaire (3) étant disposé par rapport à un axe de polarisation (x, y) des deuxièmes ondes lumineuses polarisées de manière linéaire (4) et/ ou un axe de polarisation (x, y) des troisièmes ondes lumineuses polarisées de manière linéaire (5) étant disposé par rapport à un axe de polarisation (x', y') des quatrièmes ondes lumineuses polarisées de manière linéaire (5a) de sorte que les axes de polarisation correspondants comprennent un angle qui dévie d'un angle Δα de 45°,

**caractérisé en ce que**

pour l'angle Δα, il est valable : 0° < Δα < 45° de 45°, et

que l'angle Δα est choisi en fonction d'au moins les angles ε, ε' de sorte que des non-linéarités du rapport entre le décalage de phase induit de manière magnéto-optique des ondes lumineuses polarisées de manière elliptique (6 ; 6') et le courant électrique (I) ou le champ magnétique à mesurer soient réduites par rapport au cas où Δα = 0°.

**Fig. 1**

**Fig. 2**

**Fig. 3**

**Fig. 4**

Fig. 5

Fig. 6

21